# EUROPEAN PATENT APPLICATION

(11) **EP 4 831 344 A1**
(43) Date of publication of application: **28.10.2026**
(21) Application number: 25866146.1
(22) Date of filing: 10.09.2025
(51) Int. Cl.: C23C 16/40, C07F 5/06, C23C 16/455, H10P 14/692

(54) **RAW MATERIAL COMPOSITION FOR FORMING ALUMINUM OXIDE FILM, METHOD FOR FORMING ALUMINUM OXIDE FILM, ALUMINUM OXIDE FILM, AND APPARATUS FOR PRODUCING ALUMINUM OXIDE FILM**

(30) Priority: 13.09.2024 JP 2024159247
(71) Applicant: Tosoh Corporation, Shunan-shi, Yamaguchi 746-8501 (JP); Tosoh Finechem Corporation, Yamaguchi 746-0006 (JP)
(72) Inventor: YAMAMOTO, Yuki, Ayase-shi, Kanagawa 252-1123 (JP); EBIHARA, Ryosuke, Ayase-shi, Kanagawa 252-1123 (JP); IKEMURA, Shuya, Ayase-shi, Kanagawa 252-1123 (JP); GOTO, Hajime, Ayase-shi, Kanagawa 252-1123 (JP); IWANAGA, Kohei, Ayase-shi, Kanagawa 252-1123 (JP); SUMIDA, Wataru, Shunan-shi, Yamaguchi 746-0006 (JP); TANABE, Ryouji, Shunan-shi, Yamaguchi 746-0006 (JP)
(74) Representative: Novagraaf International SA
(86) International application number: PCT/JP2025/032078
(87) International publication number: WO 2026/058916

(57) **Abstract**

Disclosed is an aluminum oxide film-forming composition containing trimethylaluminum and dimethylaluminum hydride. The content of the dimethylaluminum hydride in the aluminum oxide film-forming composition is more than 0 mass ppm and 1000 mass ppm or less.

## Description

### Technical Field

The present disclosure relates to an aluminum oxide film-forming composition, a method for forming an aluminum oxide film, an aluminum oxide film, and an aluminum oxide film production apparatus.

### Background Art

Aluminum oxide films are widely used as coating films for various mechanical components, gate insulating films for semiconductor integrated circuits, barrier films in the field of organic electronics, and the like.

A trimethylaluminum composition containing trimethylaluminum is known as a source for an aluminum oxide film.

As a method for forming an aluminum oxide film using such a trimethylaluminum composition as a source, for example, a method for forming an aluminum-containing oxide thin film is known in which an aluminum-containing oxide thin film is formed by an atomic layer deposition (ALD: Atomic Layer Deposition) method using, as a source, an aluminum-containing composition containing trimethylaluminum and dimethylaluminum hydride and an oxygen-containing compound containing an oxygen atom. Patent Literature 1 below states that mixing trimethylaluminum and dimethylaluminum hydride at a molar ratio of 4:6 to 8:2 improves the film formation rate.

### Citation List

### Patent Literature

PTL 1: Japanese Unexamined Patent Publication No. 2016-141882

### Summary of Invention

### Technical Problem

In particular, semiconductors employ highly miniaturized and highly three-dimensional structures; in order to use trimethylaluminum sources in such applications, there has been a demand for development of a technique of uniformly producing an aluminum oxide film having a thickness of about several nanometers to several tens of nanometers on a surface of a substrate having a three-dimensional structure.

However, in the method for forming an aluminum oxide film described in PTL 1, for example, when an aluminum oxide film is formed on a surface of a substrate whose surface includes a flat surface and a recessed surface such as a groove, a large difference arises between the film thickness of the aluminum oxide film on the flat surface and the film thickness of the aluminum oxide film on a side surface of the recessed surface (for example, a deep side surface of the groove), leaving room for improvement in terms of improving so-called step coverage.

An object of the present disclosure is to provide an aluminum oxide film-forming composition, a method for forming an aluminum oxide film, an aluminum oxide film, and an aluminum oxide film production apparatus that can provide improved step coverage by an aluminum oxide film even when the aluminum oxide film is formed on a surface of a substrate having a three-dimensional structure.

### Solution to Problem

The inventors of the present disclosure performed extensive studies in order to solve the problem and, as a result, have found that a composition containing trimethylaluminum and dimethylaluminum hydride, having a sufficiently low content of dimethylaluminum hydride, and serving as the source for forming an aluminum oxide film is caused to react with a reaction gas containing an oxygen atom-containing gas, to thereby improve step coverage by the aluminum oxide film even when the aluminum oxide film is formed on a surface of a substrate having a three-dimensional structure; thus, the inventors have accomplished the present disclosure.

Specifically, the contents of the present invention are as described in the Claims, and the gist of the present disclosure is as follows.
[1] An aluminum oxide film-forming composition containing trimethylaluminum and dimethylaluminum hydride,
   wherein a content of the dimethylaluminum hydride in the aluminum oxide film-forming composition is more than 0 mass ppm and 1000 mass ppm or less.
[2] The aluminum oxide film-forming composition according to [1], wherein the content of the dimethylaluminum hydride in the aluminum oxide film-forming composition is 100 mass ppm or more and 1000 mass ppm or less.
[3] The aluminum oxide film-forming composition according to [1] or [2], which does not contain dimethylaluminum chloride.
[4] The aluminum oxide film-forming composition according to any one of [1] to [3], wherein a content of boron is 100 × 10⁻⁹ mol/g or less and a content of chlorine is 300 × 10⁻⁹ mol/g or less in the aluminum oxide film-forming composition.
[5] The aluminum oxide film-forming composition according to any one of [1] to [4], wherein a total content of chromium and iron in the aluminum oxide film-forming composition is 3 × 10⁻⁹ mol/g or less.
[6] A method for forming an aluminum oxide film, the method including a reaction step of causing the aluminum oxide film-forming composition according to any one of [1] to [5] to adhere as a source to a surface of a substrate, and causing a reaction between the source and a reaction gas containing an oxygen atom-containing gas.
[7] The method for forming an aluminum oxide film according to [6], wherein the reaction gas contains ozone.
[8] The method for forming an aluminum oxide film according to [6] or [7], wherein the reaction step is performed using an atomic layer deposition method.
[9] An aluminum oxide film obtained by the method for forming an aluminum oxide film according to any one of [6] to [8].
[10] An aluminum oxide film production apparatus including:
   a source supply section configured to supply the aluminum oxide film-forming composition according to any one of [1] to [5];
   a reaction gas supply section configured to supply a reaction gas containing an oxygen atom-containing gas; and
   a reaction chamber configured to cause a reaction between the aluminum oxide film-forming composition supplied from the source supply section and the reaction gas supplied from the reaction gas supply section.

### Advantageous Effects of Invention

The present disclosure provides an aluminum oxide film-forming composition, a method for forming an aluminum oxide film, an aluminum oxide film, and an aluminum oxide film production apparatus that can provide improved step coverage by an aluminum oxide film even when the aluminum oxide film is formed on a surface of a substrate having a three-dimensional structure.

### Brief Description of Drawings

[Fig. 1] Fig. 1 is a schematic view illustrating an embodiment of an aluminum oxide film production apparatus of the present disclosure.
[Fig. 2] Fig. 2 includes (a) to (e) illustrating TEM images of cross-sections of aluminum oxide films obtained in Examples 1 to 3 and Comparative Examples 1 to 2.

### Description of Embodiments

Embodiments of the present disclosure will be described in detail by way of example. However, the present disclosure is not limited to the following embodiments. The present disclosure encompasses any combinations of features and parameters disclosed herein, and also encompasses any combinations of upper limits and lower limits of numerical values disclosed herein.

### <Aluminum oxide film-forming composition>

First, an embodiment of the aluminum oxide film-forming composition of the present disclosure will be described.

The aluminum oxide film-forming composition (hereafter also referred to as a "composition") contains trimethylaluminum (hereafter also referred to as "TMA") and dimethylaluminum hydride (hereafter also referred to as "DMAH"). The content of DMAH in the composition is more than 0 mass ppm and 1000 mass ppm or less.

The above-described composition can provide improved step coverage by an aluminum oxide film even when the aluminum oxide film is formed on a surface of a substrate having a three-dimensional structure using the composition as a source. Therefore, when the substrate having a three-dimensional structure is, for example, a substrate having a surface including a flat surface and a recessed surface such as a groove, the difference between the film thickness of the aluminum oxide film on the flat surface and the film thickness of the aluminum oxide film on a side surface of the recessed surface (for example, a deep side surface of the groove) can be reduced, and uniformity of the film thickness on the surface of the substrate having a three-dimensional structure can be improved.

Hereinafter, the composition of the present embodiment will be described in detail.

### (DMAH)

The content of DMAH in the composition is more than 0 mass ppm and 1000 mass ppm or less, and may be, for example, 800 mass ppm or less, 700 mass ppm or less, 600 mass ppm or less, 500 mass ppm or less, 400 mass ppm or less, or 300 mass ppm or less.

The content of DMAH in the composition may be 0.1 mass ppm or more, 10 mass ppm or more, 30 mass ppm or more, 50 mass ppm or more, 100 mass ppm or more, 120 mass ppm or more, or 140 mass ppm or more.

The content of DMAH in the composition may be more than 0 mass ppm and 800 mass ppm or less, 0.1 mass ppm or more and 800 mass ppm or less, or 0.1 mass ppm or more and 700 mass ppm or less.

The content of DMAH in the composition is preferably 100 mass ppm or more and 1000 mass ppm or less, more preferably 120 mass ppm or more and 800 mass ppm or less, and particularly preferably 140 mass ppm or more and 700 mass ppm or less. When the content of DMAH in the composition is 100 mass ppm or more and 1000 mass ppm or less, even when an aluminum oxide film is formed on a surface of a substrate having a three-dimensional structure using the composition as a source, step coverage by the aluminum oxide film can be further improved.

Note that the content of DMAH is the content of DMAH in a state in which the composition is in a liquid phase, and can be measured by NMR (nuclear magnetic resonance spectroscopy).

### (TMA)

The content of TMA in the composition may be 90 mass% or more, 95 mass% or more, 97 mass% or more, 98.5 mass% or more, 99 mass% or more, 99.5 mass% or more, 99.8 mass% or more, 99.9 mass% or more, or 99.99 mass% or more.

Note that the content of TMA is the content of TMA in a state in which the composition is in a liquid phase, and can be measured using a gas chromatograph (for example, GC-8A manufactured by SHIMADZU CORPORATION).

### (Boron and chlorine)

The contents of boron and chlorine in the composition are not particularly limited, but the content of boron in the composition is preferably 100 × 10⁻⁹ mol/g or less and the content of chlorine in the composition is preferably 300 × 10⁻⁹ mol/g or less.

Both of the contents of boron and chlorine are suppressed, to thereby suppress the amount of Me₂BCl and/or BCl₃ generated to at most 100 × 10⁻⁹ mol/g. This results in suppression of the amounts of generation of volatile compounds of Cr or Fe (compounds that deteriorate film thickness uniformity) generated due to Me₂BCl and/or BCl₃. As a result, uniformity of the film thickness on the surface of the substrate having a three-dimensional structure can be further improved.

Note that the content of boron is the content of boron in a state in which the composition is in a liquid phase, and can be measured by ICP-MS (inductively coupled plasma mass spectrometry, for example, Agilent 8900 manufactured by Agilent Technologies, Inc.).

Examples of the volatile compounds of Cr or Fe include CrO₂Cl₂, Me₂CrCl, Me₂FeCl, and FeCl₃.

The content of boron in the composition may be 50 × 10⁻⁹ mol/g or less, 30 × 10⁻⁹ mol/g or less, or 10 × 10⁻⁹ mol/g or less.

The content of boron in the composition may be 0.1 × 10⁻⁹ mol/g or more, 1 × 10⁻⁹ mol/g or less, or 3 × 10⁻⁹ mol/g or more.

Examples of the content of boron in the composition include 0.1 × 10⁻⁹ mol/g or more and 50 × 10⁻⁹ mol/g or less, 1 × 10⁻⁹ mol/g or more and 30 × 10⁻⁹ mol/g or less, and 3 × 10⁻⁹ mol/g or more and 10 × 10⁻⁹ mol/g or less.

The content of chlorine in the composition may be 3,000 × 10⁻⁹ mol/g or less, 2,000 × 10⁻⁹ mol/g or less, or 1,000 × 10⁻⁹ mol/g or less.

The content of chlorine in the composition may be 1 × 10⁻⁹ mol/g or more, 10 × 10⁻⁹ mol/g or less, or 30 × 10⁻⁹ mol/g or more.

Examples of the content of chlorine in the composition include 1 × 10⁻⁹ mol/g or more and 3,000 × 10⁻⁹ mol/g or less, 10 × 10⁻⁹ mol/g or more and 2,000 × 10⁻⁹ mol/g or less, and 30 × 10⁻⁹ mol/g or more and 1,000 × 10⁻⁹ mol/g or less.

Note that the content of chlorine is the content of chlorine in a state in which the composition is in a liquid phase, and can be measured by UV-Vis (ultraviolet-visible spectroscopy, for example, U-1900 manufactured by Hitachi High-Technologies Corporation).

### (Chromium and iron)

The total content of chromium and iron in the composition is not particularly limited, but is preferably 3 × 10⁻⁹ mol/g or less. Even when a small amount of Me₂BCl and/or BCl₃ is generated, when the content of chromium and iron is set to 3 × 10⁻⁹ mol/g or less, the amount of volatile compounds of chromium or iron generated can be suppressed to at most 3 × 10⁻⁹ mol/g. As a result, uniformity of the film thickness on the surface of the substrate having a three-dimensional structure can be further improved.

The total content of chromium and iron in the composition may be 3 × 10⁻⁹ mol/g or less, 2 × 10⁻⁹ mol/g or less, or 1 × 10⁻⁹ mol/g or less.

The total content of chromium and iron in the composition may be 0.01 × 10⁻⁹ mol/g or more, 0.05 × 10⁻⁹ mol/g or more, or 0.10 × 10⁻⁹ mol/g or more.

Examples of the total content of chromium and iron in the composition include 0.01 × 10⁻⁹ mol/g or more and 3 × 10⁻⁹ mol/g or less, 0.05 × 10⁻⁹ mol/g or more and 2 × 10⁻⁹ mol/g or less, and 0.10 × 10⁻⁹ mol/g or more and 1 × 10⁻⁹ mol/g or less.

Note that the contents of chromium and iron are the contents of chromium and iron in a state in which the composition is in a liquid phase, and can be measured by ICP-MS (inductively coupled plasma mass spectrometry, for example, Agilent 8900 manufactured by Agilent Technologies, Inc.).

### (Other component)

The composition preferably has a formulation in which TMA and DMAH account for 100 mass%, but may further contain another component as necessary, as long as the composition provides advantageous effects. The other component may be one or more selected from the group consisting of chlorine atom-containing components such as dimethylaluminum chloride, oxygen atom-containing components, ethyl group-containing components, and organosilicon components.

The composition does not necessarily contain dimethylaluminum chloride. In other words, the content of dimethylaluminum chloride in the composition may be 0 mass ppm.

### <Method for forming aluminum oxide film>

Next, an embodiment of the method for forming an aluminum oxide film of the present disclosure will be described.

The method for forming an aluminum oxide film of the present embodiment includes a reaction step of causing the above-described composition to adhere as a source to a surface of a substrate, and causing a reaction between the source and a reaction gas containing an oxygen atom-containing gas. Note that the term "method for forming an aluminum oxide film" used herein refers to a method for producing an aluminum oxide film, and a film formation method of an aluminum oxide film.

This formation method can provide improved step coverage by the aluminum oxide film even when the aluminum oxide film is formed on a surface of a substrate having a three-dimensional structure.

Next, the formation method will be described in detail.

In the formation method, first, the above-described composition is caused to adhere as the source to a surface of a substrate.

Examples of the substrate having a three-dimensional structure include substrates having grooves formed in the surfaces and substrates having irregularities formed in the surfaces. The present disclosure is particularly useful when an aluminum oxide film is formed on a surface of a substrate having a three-dimensional structure. In the present disclosure, the above-described aluminum oxide film-forming composition is preferably used in order to form an aluminum oxide film on a surface of a substrate having a three-dimensional structure in which grooves or holes are formed in the surface.

The substrate is placed, for example, in a reaction chamber.

When a substrate having grooves or holes (hereafter grooves and holes are collectively referred to as "grooves and the like") formed in a surface is used as the substrate having a three-dimensional structure, the width of the grooves and the like is not particularly limited, but is preferably 1 nm or more, more preferably 10 nm or more, and particularly preferably 15 nm or more.

The width of the grooves and the like is preferably 100 nm or less, more preferably 50 nm or less, and particularly preferably 20 nm or less.

Examples of the width of the grooves and the like include 1 nm or more and 100 nm or less, 10 nm or more and 50 nm or less, or 10 nm or more and 20 nm or less.

The depth of the grooves and the like from the surface is not particularly limited, but is preferably 0.001 µm or more, more preferably 0.01 µm or more, and particularly preferably 0.1 µm or more.

The depth of the grooves and the like from the surface is preferably 10 µm or less, more preferably 5 µm or less, and particularly preferably 1 µm or less.

Examples of the depth of the grooves and the like from the surface include 0.001 µm or more and 10 µm or less, 0.01 µm or more and 5 µm or less, and 0.1 µm or more and 1 µm or less.

The ratio of the depth of the grooves and the like from the surface to the width of the grooves and the like (hereafter referred to as an "aspect ratio") is not particularly limited, but is preferably 0.1 or more, more preferably 1 or more, particularly preferably 2 or more, and still more preferably 5 or more.

The aspect ratio is preferably 1000 or less, more preferably 100 or less, and particularly preferably 10 or less.

Examples of the aspect ratio include 0.1 or more and 1000 or less, 1 or more and 100 or less, 5 or more and 100 or less, and 2 or more and 10 or less.

In particular, the substrate having grooves and the like formed in a surface is preferably a substrate in which the width of the grooves and the like is 10 nm or more and 20 nm or less, the depth of the grooves and the like from the surface is 0.1 µm or more and 1 µm or less, and the aspect ratio is 5 or more and 100 or less.

The source adhered to the surface of the substrate is formed of the above-described composition. Here, since the composition is in a liquid phase at normal temperature and normal pressure, the composition is brought into contact with the surface of the substrate in a vaporized state to be adhered thereto.

The temperature of the substrate is not particularly limited, but is preferably 100°C or more, more preferably 150°C or more, and particularly preferably 200°C or more, for the reason that the resultant film has a favorable composition.

However, the temperature of the substrate is preferably 600°C or less, more preferably 500°C or less, and particularly preferably 400°C or less, for the reason that the resultant film has favorable surface smoothness.

The temperature of the substrate can be measured by, for example, a thermocouple or a commercially available thermo tape.

The supply time of the source is not particularly limited, but from the viewpoint of improving step coverage by the aluminum oxide film, the supply time is preferably 0.1 seconds or more, more preferably 0.5 seconds or more, and particularly preferably 1 second or more. Although there is no particular upper limit to the supply time of the source, the supply time of the source is preferably 60 seconds or less from the viewpoint of promptly forming a film.

The pressure of the atmosphere around the substrate (for example, the atmosphere in the reaction chamber) is not particularly limited, but is usually less than atmospheric pressure, and is preferably 3990 Pa or less, more preferably 1330 Pa or less, and particularly preferably 665 Pa or less, for the reason that the resultant film has a favorable composition.

Excess source gas is preferably exhausted. In this case, inhibition of the reaction between the reaction gas and the adhered source by the excess source gas is suppressed.

The exhaust can be performed either by reducing pressure or by purging with an inert gas. Pressure reduction and purging with an inert gas may each be performed alone, or may be used in combination.

Examples of the inert gas include noble gases such as argon and nitrogen. These may each be used alone or as a mixture of two or more.

After the source is caused to adhere to the surface of the substrate, a reaction is caused between the source and a reaction gas containing an oxygen atom-containing gas.

Examples of the oxygen atom-containing gas include water vapor, oxygen, hydrogen peroxide, and ozone. These may each be used alone or as a mixture of two or more.

The oxygen atom-containing gas preferably contains ozone. Ozone has a higher oxidizing power than water vapor and oxygen. As a result, the reaction proceeds efficiently, an aluminum oxide film is efficiently formed, and step coverage by the aluminum oxide film is further improved.

The reaction between the reaction gas and the source provides film formation of an aluminum oxide film.

Excess reaction gas is preferably exhausted. In this case, inhibition of adhesion of the source supplied later onto the aluminum oxide film by the excess reaction gas is suppressed.

The exhaust can be performed either by reducing pressure or by purging with an inert gas. Pressure reduction and purging with an inert gas may each be performed alone, or may be used in combination.

Examples of the inert gas include noble gases such as argon and nitrogen. These may each be used alone or as a mixture of two or more.

The film formation temperature can be adjusted, for example, by heating the substrate. The film formation temperature is not particularly limited as long as it is the reaction initiation temperature or more, and examples of the film formation temperature include 400°C or less, 300°C or less, 200°C or less, 150°C or less, and 100°C or less.

The supply time of the reaction gas is not particularly limited, but from the viewpoint of improving step coverage by the aluminum oxide film, the supply time is preferably 0.5 seconds or more, more preferably 1 second or more, and particularly preferably 2 seconds or more. Although there is no particular upper limit to the supply time of the reaction gas, but the supply time of the reaction gas is preferably 60 seconds or less from the viewpoint of promptly forming the film.

The number of times of the reaction step performed may be only once, or may be a plurality of times. The number of times of the reaction step performed can be appropriately determined in accordance with the thickness of the aluminum oxide film to be formed on the surface of the substrate.

The reaction step may be performed by a chemical vapor deposition (CVD: Chemical Vapor Deposition) method or by an atomic layer deposition (ALD: Atomic Layer Deposition) method, but from the viewpoint of further improving step coverage by the aluminum oxide film, the reaction step is preferably performed by the ALD method.

Note that, in the reaction step, the vapor pressure of DMAH is higher than the vapor pressure of TMA in the composition in a liquid phase state and hence the content of DMAH in the composition tends to decrease. Therefore, the content of DMAH in the composition is preferably adjusted to be constant as necessary. In this case, quality of the resultant aluminum oxide film can be stabilized.

The content of DMAH can be adjusted, for example, by supplying DMAH into the composition.

### <Aluminum oxide film production apparatus>

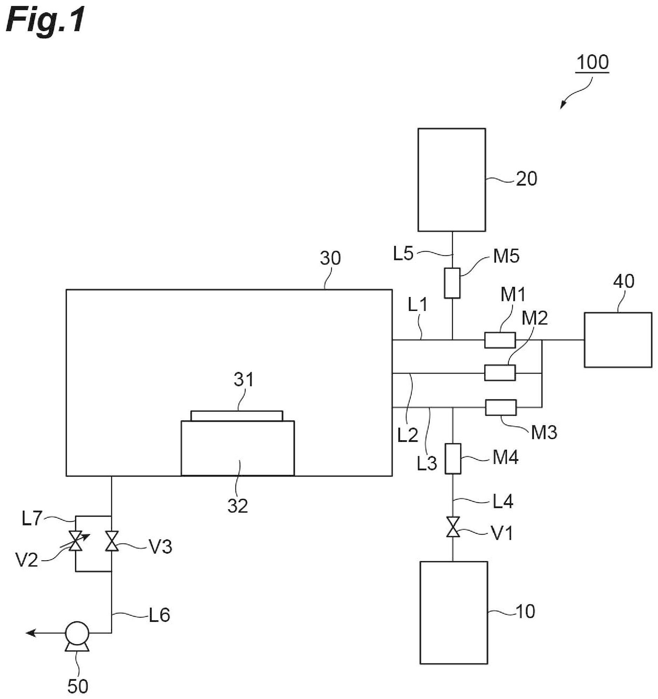

Next, an embodiment of the aluminum oxide film production apparatus of the present disclosure will be described with reference to Fig. 1.

As illustrated in Fig. 1, an aluminum oxide film production apparatus 100 includes a source supply section 10 configured to supply the above-described composition, a reaction gas supply section 20 configured to supply a reaction gas containing an oxygen atom-containing gas, and a reaction chamber 30 configured to cause a reaction between the aluminum oxide film-forming composition supplied from the source supply section 10 and the reaction gas supplied from the reaction gas supply section 20. The reaction gas supply section 20 may further include an ozone supply source as necessary. The ozone supply source may specifically be an ozone generator.

Note that a support section 32 configured to support a substrate 31 may be provided in the reaction chamber 30.

The aluminum oxide film production apparatus 100 may further include a carrier/dilution gas supply section 40 configured to supply a carrier gas and a dilution gas.

The aluminum oxide film production apparatus 100 may include a reaction gas purge line L1, a purge-up gas line L2, and a source gas purge line L3 that connect the carrier/dilution gas supply section 40 and the reaction chamber 30, and the reaction gas purge line L1, the purge-up gas line L2, and the source gas purge line L3 may be respectively provided with mass flow controllers M1, M2, and M3.

The aluminum oxide film production apparatus 100 may further include a source gas supply line L4 that connects the source gas purge line L3 and the source supply section 10, and a reaction gas supply line L5 that connects the reaction gas purge line L1 and the reaction gas supply section 20, and the source gas supply line L4 may be provided with a valve V1 and a mass flow controller M4. The reaction gas supply line L5 may be provided with a mass flow controller M5.

Furthermore, the aluminum oxide film production apparatus 100 may further include an exhaust line L6 connected to the reaction chamber 30, and the exhaust line L6 may be provided with a valve V3 and an exhaust pump 50 in this order from the reaction chamber 30. The exhaust line L6 may be provided with a branch line L7, and the branch line L7 may be provided with a variable flow rate valve V2.

The aluminum oxide film production apparatus 100 uses the above-described composition as the source, includes the following steps (1) and (5), and may include the following steps (2) to (4) and (6) to (8). The reaction step is performed one or more times to thereby form an aluminum oxide film.

The steps (2) to (4) and (6) to (8) may be added or omitted as necessary, and may also be performed simultaneously.

At this time, even when the aluminum oxide film is formed on the surface of the substrate 31 having a three-dimensional structure, step coverage by the aluminum oxide film can be improved.
(1) First, with the valve V1 and the variable flow rate valve V2 opened and V3 closed, while exhausting by the exhaust pump 50, the source in a vaporized state is supplied from the source supply section 10 through the source gas supply line L4 and the source gas purge line L3 into the reaction chamber 30 to adhere to the surface of the substrate 31. At this time, the opening degree of the variable flow rate valve V2 may be adjusted to adjust the pressure in the reaction chamber 30.
(2) Next, after closing the valve V1 to stop supply of the source, gas in the reaction chamber 30 is exhausted through the exhaust line L6 by the exhaust pump 50. At this time, the exhaust may be performed by opening the valve V3 after closing the variable flow rate valve V2.
(3) Next, as necessary, a dilution gas may be supplied from the carrier/dilution gas supply section 40 through the source gas purge line L3 into the reaction chamber 30 to thereby purge and exhaust excess source gas from the reaction chamber 30 through the exhaust line L6, and pressure adjustment in the reaction chamber 30 may be performed. The pressure adjustment in the reaction chamber 30 can be performed by closing the valve V3 and adjusting the opening degree of the variable flow rate valve V2.
(4) Next, supply of the dilution gas from the carrier/dilution gas supply section 40 is stopped, and with the valve V3 opened, gas in the reaction chamber 30 is exhausted through the exhaust line L6 by the exhaust pump 50.
(5) Next, with the valve V3 closed and the variable flow rate valve V2 opened, a reaction gas is supplied from the reaction gas supply section 20 through the reaction gas supply line L5 and the reaction gas purge line L1 into the reaction chamber 30, and the reaction gas is brought into contact with the source adhering to the surface of the substrate 31 to react to form an aluminum oxide film. At this time, the opening degree of the variable flow rate valve V2 may be adjusted to adjust the pressure in the reaction chamber 30.
(6) Next, after stopping supply of the reaction gas, gas in the reaction chamber 30 is exhausted through the exhaust line L6 by the exhaust pump 50.
(7) Next, as necessary, the dilution gas may be supplied from the carrier/dilution gas supply section 40 through the reaction gas purge line L1 into the reaction chamber 30, to thereby purge and exhaust excess reaction gas from the reaction chamber 30 through the exhaust line L6, and pressure adjustment in the reaction chamber 30 may be performed. The pressure adjustment in the reaction chamber 30 can be performed by closing the valve V3 and adjusting the opening degree of the variable flow rate valve V2.
(8) Next, supply of the dilution gas from the carrier/dilution gas supply section 40 is stopped, and with the valve V3 opened, gas in the reaction chamber 30 is exhausted through the exhaust line L6 by the exhaust pump 50.

### EXAMPLES

Hereinafter, the contents of the present disclosure will be described more specifically with reference to Examples, but the present disclosure is not limited to the following Examples.

### (Example 1)

The aluminum oxide film production apparatus 100 illustrated in Fig. 1 was used to repeat, as one cycle, a reaction step having the following (1) to (6) for 105 cycles under the following production conditions to produce an aluminum oxide film.

At this time, the source supplied from the source supply section 10 was a liquid-phase composition containing TMA and DMAH in which the content of DMAH was 30 mass ppm, and the reaction gas supplied from the reaction gas supply section 20 was a mixed gas of oxygen and ozone. The aluminum oxide film was produced on the surface of a substrate by an ALD method.

Note that the content of TMA in the composition was determined by the following procedure.

First, a solution prepared by diluting the composition fourfold with liquid paraffin was added dropwise into an acidic aqueous solution, and generated gas was collected. The methane concentration in the gas was measured using a gas chromatograph (GC-8A manufactured by SHIMADZU CORPORATION), and the result was used to calculate the mass-based content of TMA in the composition.

The content of DMAH in the composition was calculated using an internal standard method. Specifically, after diluting the composition with deuterated benzene to which anisole serving as an internal standard substance was added, proton NMR was measured using an NMR (nuclear magnetic resonance) apparatus (JNM-ECA 500 manufactured by JEOL Ltd.), and the integral value of the peak of anisole and the integral value of the peak of DMAH were compared to calculate the content.

### <Production conditions>

Source gas: supplied by draw-in supply at room temperature
Purge gas flowed through source gas purge line L3: argon (flow rate: 10 sccm)
Reaction gas: mixed gas of ozone and oxygen (flow rate: 25 sccm)
Purge gas flowed through reaction gas purge line: argon (flow rate: 20 sccm)
Purge-up gas flowed through purge-up gas line L2: argon (flow rate: 50 sccm)
Substrate: line-and-space pattern substrate having groove width of 50 nm, depth from surface of 1 µm, and aspect ratio of 20
Substrate temperature: 200°C (during source gas supply and during reaction gas supply)
Total pressure in reaction chamber: 133 Pa (during source gas supply and during reaction gas supply)
Note that the term "draw-in supply" refers to supply of vapor due to vaporization at room temperature by sending the vapor to the reaction chamber 30 by pressure reduction using the pump 50 without blowing gas into the source supply section 10.

### <Reaction step>

(1) With the valve V1 and the variable flow rate valve V2 opened and the valve V3 closed, while exhausting by the exhaust pump 50, the source vaporized by draw-in at room temperature is supplied from the source supply section 10, at a flow rate adjusted using the mass flow controller M4, through the source gas supply line L4 and the source gas purge line L3, into the reaction chamber 30, and is caused to adhere to the surface of the substrate for 2 seconds.
(2) After closing the valve V1 and the mass flow controller M4 to stop supply of the source, the variable flow rate valve V2 is closed and the valve V3 is opened, and the inside of the reaction chamber 30 is exhausted for 1 second by the exhaust pump 50.
(3) Argon is supplied from the carrier/dilution gas supply section 40 through the source gas purge line L3 into the reaction chamber 30 for 5 seconds to purge unreacted source in the reaction chamber 30 and exhaust the unreacted source from the reaction chamber 30 through the exhaust line L6, and pressure adjustment in the reaction chamber 30 is performed. The pressure adjustment in the reaction chamber 30 is performed by closing the valve V3 and adjusting the opening degree of the valve V2, and also by adjusting the rate of argon supplied from the carrier/dilution gas supply section 40 by the mass flow controller M3.
(4) With pressure adjusted using the variable flow rate valve V2, the reaction gas is supplied at an adjusted flow rate from the reaction gas supply section 20 through the mass flow controller M5, the reaction gas supply line L5, and the reaction gas purge line L1 into the reaction chamber 30 for 3 seconds to react with the source adhering to the surface of the substrate 31, thereby forming an aluminum oxide film.
(5) After closing the mass flow controller M5 to stop supply of the reaction gas, the variable flow rate valve V2 is closed and the valve V3 is opened, and the inside of the reaction chamber 30 is exhausted for 1 second by the exhaust pump 50 through the exhaust line L6.
(6) Argon is supplied from the carrier/dilution gas supply section 40 through the reaction gas purge line L1 into the reaction chamber 30 for 5 seconds to purge excess reaction gas in the reaction chamber 30 and exhaust the excess reaction gas from the reaction chamber 30 through the exhaust line L6, and pressure adjustment in the reaction chamber 30 is performed. The pressure adjustment in the reaction chamber 30 is performed by closing the valve V3 and adjusting the opening degree of the valve V2, and also by adjusting the rate of argon supplied from the carrier/dilution gas supply section 40 by the mass flow controller M1.

The surface roughness Rms of the aluminum oxide film obtained as described above was measured using an atomic force microscope (AFM: Atomic Force Microscope) and Rms was 0.27 nm, which indicated that a smooth film was produced.

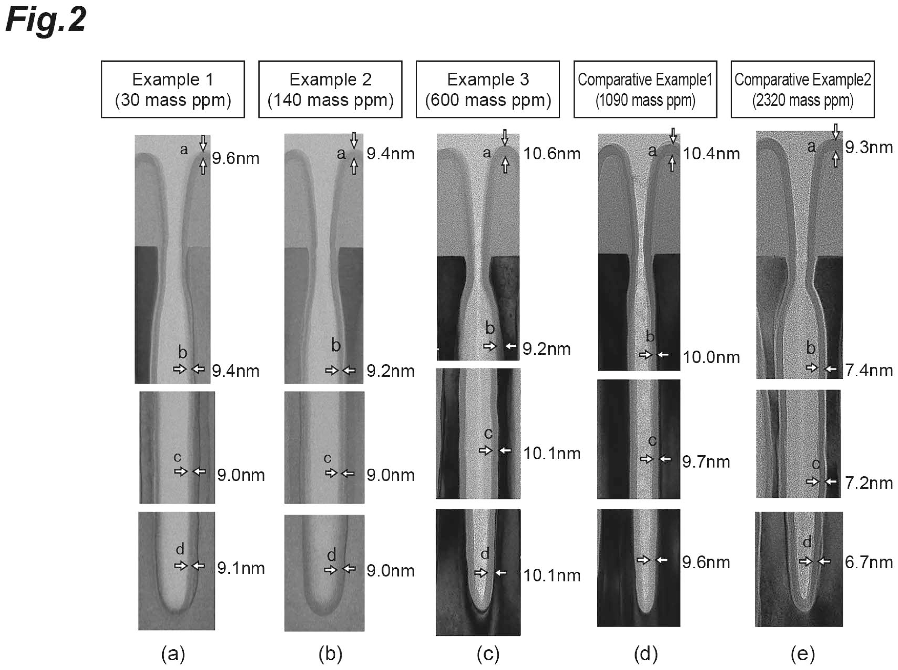

Further, the aluminum oxide film was cleaved, and cross-sectional TEM (Transmission Electron Microscope) observation was performed. The cross-sectional TEM image is illustrated in Fig. 2(a). The cross-sectional TEM image is illustrated such that the cross section is divided into a first region, a second region, and a third region in this order from the surface side toward the depth direction of the groove. Here, in the first region, the thickness of the aluminum oxide film on the surface of the substrate was defined as a, and the thickness of the aluminum oxide film on the inner surface of the groove at a depth of 100 nm from the surface of the substrate was defined as b; in the second region, the thickness of the aluminum oxide film on the inner surface of the groove at a depth of 500 nm from the surface of the substrate was defined as c; and in the third region, the thickness of the aluminum oxide film on the inner surface of the groove at a depth of 950 nm from the surface of the substrate was defined as d. Fig. 2(a) indicates that aluminum oxide was grown to a film thickness a = 9.6 nm on the surface of the substrate, and grown to a film thickness d = 9.1 nm on the inner surface of the groove at a depth of 950 nm from the surface of the substrate in the third region of the groove inner surface. These film thicknesses were used to calculate the step coverage ratio by the aluminum oxide film based on the following formula (A). The results are described in Table 1. As described in Table 1, the step coverage ratio was 94.8%. $\begin{matrix}Step coverage ratio \\ = 100 \times film thickness at depth of 950 nm from surface in third region / \\ film thickness on surface of substrate\end{matrix}$ (A)

### (Example 2)

The same procedures as in Example 1 were performed except that a liquid-phase composition having a DMAH content of 140 mass ppm was used as the source, to obtain an aluminum oxide film.

The surface roughness Rms of the obtained aluminum oxide film was measured using AFM and Rms was 0.27 nm, which indicated that a smooth film was produced.

Further, the aluminum oxide film was cleaved, and cross-sectional TEM observation was performed. The cross-sectional TEM image is illustrated in Fig. 2(b). Similarly to Example 1, the cross-sectional TEM image is illustrated such that the cross section is divided into a first region, a second region, and a third region in this order from the surface side toward the depth direction of the groove. Fig. 2(b) indicates that aluminum oxide was grown to a film thickness a = 9.4 nm on the surface of the substrate, and grown to a film thickness d = 9.0 nm on the inner surface of the groove at a depth of 950 nm from the surface of the substrate in the third region. These film thicknesses were used to calculate the step coverage ratio by the aluminum oxide film based on the above formula (A). The results are described in Table 1. As described in Table 1, the step coverage ratio was 95.7%.

### (Example 3)

The same procedures as in Example 1 were performed except that a liquid-phase composition having a DMAH content of 600 mass ppm was used as the source, to obtain an aluminum oxide film.

The surface roughness Rms of the obtained aluminum oxide film was measured using AFM and Rms was 0.27 nm, which indicated that a smooth film was produced.

Further, the aluminum oxide film was cleaved, and cross-sectional TEM observation was performed. The cross-sectional TEM image is illustrated in Fig. 2(c). Similarly to Example 1, the cross-sectional TEM image is illustrated such that the cross section is divided into a first region, a second region, and a third region in this order from the surface side toward the depth direction of the groove. Fig. 2(c) indicates that aluminum oxide was grown to a film thickness a = 10.6 nm on the surface of the substrate, and grown to a film thickness d = 10.1 nm on the inner surface of the groove at a depth of 950 nm from the surface of the substrate in the third region. These film thicknesses were used to calculate the step coverage ratio by the aluminum oxide film based on the above formula (A). The results are described in Table 1. As described in Table 1, the step coverage ratio was 95.3%.

### (Comparative Example 1)

The same procedures as in Example 1 were performed except that a liquid-phase composition having a DMAH content of 1090 mass ppm was used as the source, to produce an aluminum oxide film.

The surface roughness Rms of the obtained aluminum oxide film was measured using AFM and Rms was 0.23 nm, which indicated that a smooth film was produced.

Further, the aluminum oxide film was cleaved, and cross-sectional TEM observation was performed. The cross-sectional TEM image is illustrated in Fig. 2(d). Similarly to Example 1, the cross-sectional TEM image is illustrated such that the cross section is divided into a first region, a second region, and a third region in this order from the surface side toward the depth direction of the groove. Fig. 2(d) indicates that aluminum oxide was grown to a film thickness a = 10.4 nm on the surface of the substrate, and grown to a film thickness d = 9.6 nm on the inner surface of the groove at a depth of 950 nm from the surface of the substrate in the third region. These film thicknesses were used to calculate the step coverage ratio by the aluminum oxide film based on the above formula (A). The results are described in Table 1. As described in Table 1, the step coverage ratio was 92.3%.

### (Comparative Example 2)

The same procedures as in Example 1 were performed except that a liquid-phase composition having a DMAH content of 2320 mass ppm was used as the source, to obtain an aluminum oxide film.

The surface roughness Rms of the obtained aluminum oxide film was measured using AFM and Rms was 0.23 nm, which indicated that a smooth film was produced.

Further, the aluminum oxide film was cleaved, and cross-sectional TEM observation was performed. The cross-sectional TEM image is illustrated in Fig. 2(e). Similarly to Example 1, the cross-sectional TEM image is illustrated such that the cross section is divided into a first region, a second region, and a third region in this order from the surface side toward the depth direction of the groove. Fig. 2(e) indicates that aluminum oxide was grown to a film thickness a = 9.3 nm on the surface of the substrate, and grown to a film thickness d = 6.7 nm on the inner surface of the groove at a depth of 950 nm from the surface of the substrate in the third region. These film thicknesses were used to calculate the step coverage ratio by the aluminum oxide film based on the above formula (A). The results are described in Table 1. As described in Table 1, the step coverage ratio was 72.0%.

Note that, for Example 1 and Comparative Example 2, the contents of B, Cl, Cr, and Fe in the composition were measured by the following analyses. The results are described in Table 2. Table 2 also describes the total content of Cr and Fe.

### (Preparation of analysis sample)

A solution obtained by diluting the composition to be analyzed about 30-fold with an organic solvent was added dropwise into an acidic aqueous solution to obtain a hydrolyzed solution of the composition. The organic solvent employed was xylene.

### (B, Cr, and Fe)

The contents of B, Cr, and Fe contained in the composition were calculated by measuring B, Cr, and Fe in the aqueous layer of the hydrolyzed solution using an ICP-MS (inductively coupled plasma mass spectrometry) apparatus Agilent 8900 manufactured by Agilent Technologies, Inc., calculating the molar-based contents of the metal atoms, and then dividing the molar-based contents by the mass (g) of the composition.

### (Cl)

The content of Cl contained in the composition was calculated by suspending the aqueous layer of the hydrolyzed solution in an aqueous silver nitrate solution, measuring absorbance of the suspension with a spectrophotometer U-1900 manufactured by Hitachi High-Technologies Corporation, calculating the molar-based content of chlorine atoms, and dividing the molar-based content by the mass (g) of the composition.

**Table 1**

| | DMAH content | Step coverage ratio |
|---|---|---|
| | mass ppm | % |
| Example 1 | 30 | 94.8 |
| Example 2 | 140 | 95.7 |
| Example 3 | 600 | 95.3 |
| Comparative Example 1 | 1090 | 92.3 |
| Comparative Example 2 | 2320 | 72.0 |

**Table 2**

| | Elemental Content in composition | | | | | Step coverage ratio |
|---|---|---|---|---|---|---|
| | B | Cl | Cr | Fe | Cr+Fe | |
| | ×10⁻⁹mol/g | ×10⁻⁹mol/g | ×10⁻⁹mol/g | ×10⁻⁹mol/g | ×10⁻⁹mol/g | % |
| Example 1 | <6.48 | <197 | <0.10 | <0.18 | <0.28 | 94.8 |
| Comparative Example 2 | <6.48 | 3582 | 0.62 | 2.51 | 3.13 | 72.0 |

The above results indicated that the step coverage ratios of Examples 1 to 3 were higher than the step coverage ratios of Comparative Examples 1 to 2.

This indicates that the aluminum oxide film-forming composition of the present disclosure can provide improved step coverage by an aluminum oxide film even when the aluminum oxide film is formed on a surface of a substrate having a three-dimensional structure.

### Reference Signs List

- 10: source supply section
- 20: reaction gas supply section
- 30: reaction chamber
- 100: aluminum oxide film production apparatus

## Claims

1. An aluminum oxide film-forming composition comprising trimethylaluminum and dimethylaluminum hydride,
wherein a content of the dimethylaluminum hydride in the aluminum oxide film-forming composition is more than 0 mass ppm and 1000 mass ppm or less.

2. The aluminum oxide film-forming composition according to claim 1, wherein the content of the dimethylaluminum hydride in the aluminum oxide film-forming composition is 100 mass ppm or more and 1000 mass ppm or less.

3. The aluminum oxide film-forming composition according to claim 1 or 2, which does not contain dimethylaluminum chloride.

4. The aluminum oxide film-forming composition according to any one of claims 1 to 3, wherein a content of boron is 100 × 10⁻⁹ mol/g or less and a content of chlorine is 300 × 10⁻⁹ mol/g or less in the aluminum oxide film-forming composition.

5. The aluminum oxide film-forming composition according to any one of claims 1 to 4, wherein a total content of chromium and iron in the aluminum oxide film-forming composition is 3 × 10⁻⁹ mol/g or less.

6. A method for forming an aluminum oxide film, the method comprising a reaction step of causing the aluminum oxide film-forming composition according to any one of claims 1 to 5 to adhere as a source to a surface of a substrate, and causing a reaction between the source and a reaction gas containing an oxygen atom-containing gas.

7. The method for forming an aluminum oxide film according to claim 6, wherein the reaction gas contains ozone.

8. The method for forming an aluminum oxide film according to claim 6 or 7, wherein the reaction step is performed using an atomic layer deposition method.

9. An aluminum oxide film obtained by the method for forming an aluminum oxide film according to any one of claims 6 to 8.

10. An aluminum oxide film production apparatus comprising:
a source supply section configured to supply the aluminum oxide film-forming composition according to any one of claims 1 to 5;
a reaction gas supply section configured to supply a reaction gas containing an oxygen atom-containing gas; and
a reaction chamber configured to cause a reaction between the aluminum oxide film-forming composition supplied from the source supply section and the reaction gas supplied from the reaction gas supply section.
